(19) Europäisches Patentamt

European Patent Office

Office européen des brevets

(11) Veröffentlichungsnummer: **0 299 259 B1**

(12) **EUROPÄISCHE PATENTSCHRIFT**

(45) Veröffentlichungstag der Patentschrift: **09.03.94**

(21) Anmeldenummer: **88110173.7**

(22) Anmeldetag: **25.06.88**

(51) Int. Cl.5: **H03K 17/945**, H03F 3/343

(54) Elektronisches, vorzugsweise berührungslos arbeitendes Schaltgerät.

(30) Priorität: **11.07.87 DE 3723008**

(43) Veröffentlichungstag der Anmeldung:
**18.01.89 Patentblatt 89/03**

(45) Bekanntmachung des Hinweises auf die
Patenterteilung:
**09.03.94 Patentblatt 94/10**

(84) Benannte Vertragsstaaten:
**CH DE FR GB LI SE**

(56) Entgegenhaltungen:
**EP-A- 0 212 384**
**WO-A-83/04458**
**DE-A- 2 722 510**
**DE-C- 3 605 499**

**Patent Abstracts of Japan Band 10, Nr. 145
(E-407)(2202), 28. Mai 1986**

(73) Patentinhaber: **i f m electronic gmbh
Teichstrasse 4
D-45127 Essen(DE)**

(72) Erfinder: **Lamarche, Jean-Luc, Dipl.-Ing.
Zeppelinstrasse 1
D-7994 Langenargen(DE)**

(74) Vertreter: **Gesthuysen, Hans Dieter, Dipl.-Ing.
et al
Patentanwälte Gesthuysen + von Rohr
Postfach 10 13 33
D-45013 Essen (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services
(3.10/3.09/3.3.3)

**Beschreibung**

Die Erfindung betrifft ein elektronisches, vorzugsweise berührungslos arbeitendes Schaltgerät, mit einem von außen beeinflußbaren Anwesenheitsindikator, z. B. einem Oszillator, mit einem dem Anwesenheitsindikator nachgeordneten Schaltverstärker, mit einem von dem Anwesenheitsindikator über den Schaltverstärker steuerbaren elektronischen Schalter, z. B. einem Transistor, einem Thyristor oder einem Triac, mit einer Speiseschaltung zur Darstellung der Speisespannung für den Anwesenheitsindikator und für den Schaltverstärker, bei dem der Schaltverstärker eine Ausgangsstufe mit mindestens einem Ansteuertransistor und einem dem Ansteuertransistor nachgeschalteten Ausgangstransistor aufweist (vgl. die DE - A - 27 22 510).

Elektronische Schaltgeräte der hier grundsätzlich in Rede stehenden Art sind kontaktlos ausgeführt und werden seit nunmehr etwa zwanzig Jahren in zunehmendem Maße anstelle von elektrischen, mechanisch betätigten Schaltgeräten, die kontaktbehaftet ausgeführt sind, verwendet, insbesondere in elektrischen bzw. elektronischen Meß-, Steuer- und Regelkreisen. Das gilt insbesondere für sogenannte Annäherungsschalter, d. h. für elektronische Schaltgeräte, die berührungslos arbeiten. Mit solchen Annäherungsschaltern wird indiziert, ob sich ein Beeinflussungselement, für das der entsprechende Annäherungsschalter sensitiv ist, dem Annäherungsschalter hinreichend weit genähert hat. Hat sich nämlich ein Beinflussungselement, für das der entsprechende Annäherungsschalter sensitiv ist, dem Annäherungsschalter hinreichend weit genähert, so steuert der einen wesentlichen Bestandteil des Annäherungsschalters bildende Anwesenheitsindikator den elektronischen Schalter um; bei einem als Schließer ausgeführten Schaltgerät wird der nichtleitende elektronische Schalter nunmehr leitend, während bei einem als Öffner ausgeführten Schaltgerät der leitende elektronische Schalter nunmehr sperrt. (Mit Schaltgeräten der in Rede stehenden Art kann auch indiziert werden, ob eine physikalische Größe eines Beeinflussungsmediums, für die das Schaltgerät sensitiv ist, einen entsprechenden Wert erreicht hat.)

Wesentlicher Bestandteil von elektronischen Schaltgeräten der zuvor beschriebenen Art ist also u. a. der von außen beeinflußbare Anwesenheitsindikator.

Als Anwesenheitsindikator kann z. B. ein induktiv oder kapazitiv beeinflußbarer Oszillator vorgesehen sein; es handelt sich dann um induktive oder kapazitive Annäherungsschalter (vgl. z. B. die deutschen Offenlegungsschriften bzw. Auslegeschriften bzw. Patentschriften 19 51 137, 19 66 178, 19 66 213, 20 36 840, 21 27 956, 22 03 038, 22 03 039, 22 03 040, 22 03 906, 23 30 233, 23 31 732, 23 56 490, 26 13 423, 26 16 265, 26 16 773, 26 28 427, 27 11 877, 27 44 785, 29 43 911, 30 04 829, 30 38 692, 31 20 884, 32 09 673, 32 38 396, 33 20 975, 33 26 440, 33 27 329, 34 20 236, 34 27 498, 35 19 714, 36 05 499 und 36 38 409). Als Anwesenheitsindikator kann auch ein Fotowiderstand, eine Fotodiode oder ein Fototransistor vorgesehen sein; es handelt sich dann um optoelektronische Annäherungsschalter (vgl. z. B. die deutschen Offenlegungsschriften 28 24 582, 30 38 102, 33 27 328, 35 14 643, 35 18 025 und 36 05 885).

Bei induktiven Annäherungsschaltern gilt für den Oszillator, solange ein Metallteil einen vorgegebenen Abstand noch nicht erreicht hat, K x V = 1 mit K = Rückkopplungsfaktor und V = Verstärkungsfaktor des Oszillators, d. h. der Oszillator schwingt. Erreicht das entsprechende Metallteil den vorgeschriebenen Abstand, so führt die zunehmende Bedämpfung des Oszillators zu einer Verringerung des Verstärkungsfaktors V, so daß K x V < 1 wird, d. h. der Oszillator hört auf zu schwingen. Bei kapazitiven Annäherungsschaltern gilt für den Oszillator, solange ein Ansprechkörper die Kapazität zwischen einer Ansprechelektrode und einer Gegenelektrode noch nicht hinreichend vergrößert hat, also einen vorgegebenen Abstand noch nicht erreicht hat, K x V < 1, d. h. der Oszillator schwingt nicht. Erreicht der Ansprechkörper den vorgegebenen Abstand, so führt die steigende Kapazität zwischen der Ansprechelektrode und der Gegenelektrode zu einer Vergrößerung des Rückkopplungsfaktors K, so daß K x V = 1 wird, d. h. der Oszillator beginnt zu schwingen. Bei beiden Ausführungsformen - induktiver Annäherungsschalter und kapazitiver Annäherungsschalter - wird abhängig von den unterschiedlichen Zuständen des Oszillators der elektronische Schalter, z. B. ein Transistor, ein Thyristor oder ein Triac, gesteuert.

Optoelektronische Annäherungsschalter weisen einen Lichtsender und einen Lichtempfänger auf und werden auch als Lichtschranken bezeichnet. Dabei unterscheidet man zwischen einem Lichtschrankentyp, bei dem der Lichtsender und der Lichtempfänger auf entgegengesetzten Seiten einer Überwachungsstrecke angeordnet sind, und einem Lichtschrankentyp, bei dem der Lichtsender und der Lichtempfänger am gleichen Ende einer Überwachungsstrecke angeordnet sind, während ein am anderen Ende der Überwachungsstrecke angeordneter Reflektor den vom Lichtsender ausgehenden Lichtstrahl zum Lichtempfänger zurückreflektiert. In beiden Fällen spricht der Anwesenheitsindikator an, wenn der normalerweise vom Lichtsender zum Lichtempfänger gelangende Lichtstrahl durch ein in die Überwachungsstrecke gelangtes Beeinflussungselement unterbrochen wird. Es gibt jedoch auch Lichtschranken des zuletzt beschriebenen Lichtschrankentyps, bei dem der vom Lichtsender kommende Lichtstrahl nur durch ein entsprechendes Beeinflussungselement zum Lichtempfänger zurückreflektiert wird.

Elektronische, berührungslos arbeitende Schaltgeräte sind anfangs mit einer Reihe von Problemen behaftet gewesen, - gemessen an elektrischen, mechanisch betätigten Schaltgeräten -, nämlich u. a. mit dem Problemen "Darstellung einer Speisespannung für den Anwesenheitsindikator und den Schaltverstärker", "Ausbildung des Anwesenheitsindikators", "Kurzschlußfestigkeit" und "Einschaltimpulsverhinderung". Mit diesen Problemen und deren Lösungen (und mit anderen bei elektronischen, berührungslos arbeitenden Schaltgeräten relevanten Problemen und deren Lösungen) befassen sich z. B. die deutschen Offenlegungsschriften bzw. Auslegeschriften bzw. Patentschriften (19 51 137, 19 66 178, 19 66 213, 20 36 840, 21 27 956, 22 03 039, 22 03 040, 22 03 906, 23 30 233, 23 31 732, 23 56 490, 26 13 423, 26 16 265, 26 16 773, 26 28 427, 27 11 877, 27 44 785, 29 43 911, 30 04 829, 30 38 102, 30 38 141, 30 38 692, 31 20 884, 32 05 737, 32 09 673, 32 14 836, 32 38 396, 33 20 975, 33 26 440, 33 27 328, 33 27 329, 34 20 236, 34 27 498, 35 19 714, 35 29 827, 36 05 199, 36 05 885 und 36 38 409).

Bei elektronischen Schaltgeräten, die über einen Außenleiter mit einem Pol einer Betriebsspannungsquelle und nur über einen weiteren Außenleiter mit einem Anschluß eines Verbrauchers verbindbar sind, ist die Darstellung einer Speisespannung bzw. eines Speisestroms für den Anwesenheitsindikator und für den Schaltverstärker nicht problemlos, weil ja sowohl im leitenden Zustand als auch im gesperrten Zustand des Schaltgerätes die Speisespannung bzw. der Speisestrom dargestellt werden muß.

Es ist belanglos, ob man von Darstellung einer Speisespannung oder von Darstellung eines Speisestroms spricht. Darstellung steht hier für Ableitung aus dem am Schaltgerät auftretenden Spannungsabfall bzw. aus dem über das Schaltgerät geführten Betriebsstrom (leitender Zustand) bzw. aus der am Schaltgerät anstehenden Betriebsspannung bzw. aus dem über das Schaltgerät fließenden Reststrom (gesperrter Zustand). Es ist deshalb belanglos, ob man von Darstellung einer Speisespannung oder von Darstellung eines Speisestroms spricht, weil der Anwesenheitsindikator und der Schaltverstärker selbstverständlich eine Speisespannung und einen Speisestrom benötigen.

Von ihrer Funktion als Schaltgeräte her soll bei den in Rede stehenden Schaltgeräten im leitenden Zustand praktisch kein Spannungsabfall auftreten und im gesperrten Zustand praktisch kein Reststrom fließen. Da aber dann, wenn bei Schaltgeräten mit nur zwei Außenleitern im leitenden Zustand kein Spannungsabfall aufträte, auch keine Speisespannung für den Anwesenheitsindikator und den Schaltverstärker gewonnen werden könnte, und dann, wenn im gesperrten Zustand kein Reststrom flösse, auch kein Speisestrom gewonnen werden könnte, gilt für alle elektronischen Schaltgeräte mit nur zwei Außenleitern, daß im leitenden Zustand ein Spannungsabfall auftritt und im gesperrten Zustand ein Reststrom fließt.

Aus dem, was zuvor ausgeführt worden ist, folgt, daß dann, wenn schon, ungewollt, aber funktionsnotwendig bei elektronichen Schaltgeräten mit nur zwei Außenleitern im leitenden Zustand ein Spannungsabfall auftritt und im gesperrten Zustand ein Reststrom fließt, der Spannungsabfall und der Reststrom so gering wie möglich sein sollen.

Einleitend ist gesagt, daß zu dem elektronischen Schaltgerät, von dem die Erfindung ausgeht, u. a. ein dem Anwesenheitsindikator nachgeordneter Schaltverstärker und ein elektronischer Schalter gehören und daß der elektronische Schalter von dem Anwesenheitsindikator über den Schaltverstärker steuerbar ist. Schaltverstärker ist hier ganz allgemein zu verstehen und umfaßt die gesamte Schaltung zwischen dem Signalausgang des Anwesenheitsindikators und dem Steuereingang des elektronischen Schalters, also den gesamten Signalübertragungsweg zwischen dem Anwesenheitsindikator und dem elektronischen Schalter. Selbstverständlich kann der so verstandene Schaltverstärker neben der Ausgangsstufe weitere Funktionseinheiten aufweisen, z. B. einen Demodulator und einen Schmitttrigger.

Elektronische Schaltgeräte der in Rede stehenden Art werden u. a. mit antivalenten Ausgängen realisiert, d. h., in der "Relais-Sprache" bzw. in der "Schütz-Sprache", als Wechsler oder auch als Schließer und als Öffner. Dazu weist dann die Ausgangsstufe des Schaltverstärkers zwei antivalent angesteuerte Ausgangstransistoren auf. Damit ist folgendes Problem verbunden:
Die Ansteuerung der Ausgangstransistoren der Ausgangsstufe des Schaltverstärkers ist so dimensioniert, daß der Ausgangstransistor den maximal geforderten Ausgangstrom führen kann. Soll z. B. ein Ausgangstransistor mit einer Stromverstärkung von 30 einen Ausgangstrom von 3 mA führen können, so ist die Ansteuerung des Ausgangstransistors so dimensioniert, daß ein Ansteuerstrom von 100 $\mu$A fließt. Dieser Ansteuerstrom fließt z. B. auch dann über die Basis-Emitter-Strecke des den Öffner realisierenden Ausgangstransistors, wenn das Schaltgerät als Schließer verwendet wird und der Anwesenheitsindikator nicht beeinflußt ist, ein als Anwesenheitsindikator vorgesehener Oszillator also schwingt. Der den Öffner realisierende Ausgangstransistor verbraucht also z. B. 100 $\mu$A, obwohl der dadurch leitende Ausgangstransistor überhaupt nicht gebraucht wird. Die Tatsache, daß überflüssigerweise ein Ansteuerstrom von z. B. 100 $\mu$A verbraucht wird, ist besonders dann nachteilig, wenn das Schaltgerät nur zwei Außenleiter aufweist, es sich also um ein Zweileiter-Schaltgerät handelt. Hier ist der überflüssigerweise verbrauchte Ansteuerstrom ja Teil des nicht gewollten, aber funktionsnotwendig fließenden Reststromes; ein Ansteuerstrom von z. B. 100 $\mu$A macht etwa ein Viertel des Reststromes aus.

In elektrischen Schaltgeräten der in Rede stehenden Art werden seit längerem integrierte Schaltkreise verwendet, die zumindest einen Teil des Anwesenheitsindikators, den Schaltverstärker und zumindest einen Teil der Speiseschaltung zur Darstellung der Speisespannung für den Anwesenheitsindikator und den Schaltverstärker enthalten. Es handelt sich dabei häufig um kundenspezifische integrierte Schaltkreise, die nur dann preisgünstig entwickelt und hergestellt werden können, wenn sie in großen Stückzahlen eingesetzt werden. Folglich werden für elektronische Schaltgeräte der hier in Rede stehenden Art universell verwendbare integrierte Schaltkreise angestrebt, d. h. ein entsprechender integrierter Schaltkreis wird für Gleichspannungs-Schaltgeräte und für Wechselspannungs-Schaltgeräte, für Dreileiter-Schaltgeräte und für Zweileiter-Schaltgeräte, für Schließer-Schaltgeräte, für Öffner-Schaltgeräte, für Wechsler-Schaltgeräte und für Schließer- und Öffner-Schaltgeräte eingesetzt. Das heißt in bezug auf das zuvor angesprochene Problem, daß auch bei Zweileiter-Schaltgeräten, die nur als Schließer-Schaltgeräte oder nur als Öffner-Schaltgeräte funktionieren, Ansteuerstrom verbraucht wird, der nicht gebraucht wird.

Das in Verbindung mit elektronischen Schaltgeräten der eingangs beschriebenen Art aufgezeigte Problem - Verbrauch von Ansteuerstrom, der nicht gebraucht wird - tritt aber nicht nur bei elektronischen Schaltgeräten der in Rede stehenden Art auf. Vielmehr ist dieses Problem auch dann relevant, wenn entsprechende Ausgangsstufen anderweitig realisiert sind, z. B. in Verstärkern.

Schließlich ist das behandelte Problem des Verbrauchs von nicht benötigtem Ansteuerstrom auch dann relevant, wenn der Ausgangstransistor einer Ausgangsstufe lastabhängig mal einen größeren, mal aber auch nur einen kleineren Ausgangsstrom führen muß.

Der Erfindung liegt folglich die Aufgabe zugrunde, das bekannte Schaltgerät, von dem die Erfindung ausgeht, so auszugestalten und weiterzubilden, daß der Ausgangstransistor der Ausgangsstufe des Schaltverstärkers stets nur den benötigten Ansteuerstrom verbraucht, - bzw. eine entsprechende Ausgangsstufe anzugeben, die stets nur den benötigten Ansteuerstrom verbraucht.

Das erfindungsgemäße elektronische Schaltgerät, bei dem die zuvor hergeleitete und dargelegte Aufgabe gelöst ist, ist nun dadurch gekennzeichnet, daß dem Ausgangstransistor ein Hilfstransistor, ein Hilfswiderstand und ein passives Spannungserhöhungselement, z. B. eine Diode, eine Zenerdiode oder ein Widerstand, zugeordnet ist und daß der Kollektorstrom des Hilfstransistors - direkt oder indirekt - durch den Ansteuertransistor geschaltet ist, der Hilfswiderstand einerseits an den Emitter des Hilfstransistors und andererseits an die Basis des Ausgangstransistors angeschlossen ist und der Basisstrom des Ausgangstransistors ausschließlich durch den Emitterstrom des Hilfstransistors gebildet ist sowie das Spannungserhöhungselement einerseits mit der Basis des Hilfstransistors und einer Stromquelle, andererseits mit dem Kollektor des Ausgangstransistors verbunden ist, so daß die Basis des Hilfstransistors potentialmäßig dem Kollektor des Ausgangstransistors folgt, jedoch um eine durch das Spannungserhöhungselement vorgegebene Spannung über dem Potential des Kollektors liegt.

Bei dem erfindungsgemäßen elektronischen Schaltgerät wird dem Ausgangstransistor stets nur soviel Ansteuerstrom geliefert, wie er in seiner durch die Belastung im Kollektor-Emitter-Kreis bedingten Funktion benötigt, - und zwar dadurch, daß die Kollektor-Emitter-Spannung $U_{CE}$ des Ausgangstransistors geregelt wird, beispielsweise auf einen Wert $U_{CE} \leq 0{,}8$ V.

Wie bereits angedeutet, hat die Lehre der Erfindung auch für sich Bedeutung, also losgelöst von ihrer Anwendung bei einem elektronischen Schaltgerät. Deshalb ist Gegenstand der Erfindung auch eine Ausgangsstufe eines Schaltverstärkers, mit mindestens einem Ansteuertransistor und einem dem Ansteuertransistor nachgeschalteten Ausgangstransistor, die dadurch gekennzeichnet ist, daß dem Ausgangstransistor ein Hilfstransistor, ein Hilfswiderstand und ein passives Spannungserhöhungselement, z. B. eine Diode, eine Zenerdiode oder ein Widerstand, zugeordnet ist und daß der Kollektorstrom des Hilfstransistors - direkt oder indirekt - durch den Ansteuertransistor geschaltet ist, der Hilfswiderstand einerseits an den Emitter des Hilfstransistors und andererseits an die Basis des Ausgangstransistors angeschlossen ist und der Basisstrom des Ausgangstransistors ausschließlich durch den Emitterstrom des Hilfstransistors gebildet ist sowie das Spannungserhöhungselement einerseits mit der Basis des Hilfstransistors und einer Stromquelle, andererseits mit dem Kollektor des Ausgangstransistors verbunden ist, so daß die Basis des Hilfstransistors potentialmäßig dem Kollektor des Ausgangstransistors folgt, jedoch um eine durch das Spannungserhöhungselement vorgegebene Spannung über dem Potential des Kollektors liegt.

Im folgenden werden nun das erfindungsgemäße elektronische Schaltgerät sowie Ausgestaltungen und Weiterbildungen der Lehre der Erfindung anhand einer lediglich Ausführungsbeispiele darstellenden Zeichnung ausführlicher erläutert; es zeigt

Fig. 1 ein Blockschaltbild eines elektronischen, berührungslos arbeitenden Schaltgerätes,

Fig. 2 ein vereinfachtes Schaltbild eines Teils des erfindungsgemäßen elektronischen Schaltgerätes, nämlich ein erstes Ausführungsbeispiel einer Ausgangsstufe des Schaltverstärkers, und

Fig. 3 wiederum ein vereinfachtes Schaltbild eines Teils des erfindungsgemäßen elektronischen Schaltgerätes, nämlich ein zweites Ausführungsbeispiel der Ausgangsstufe des Schaltverstärkers.

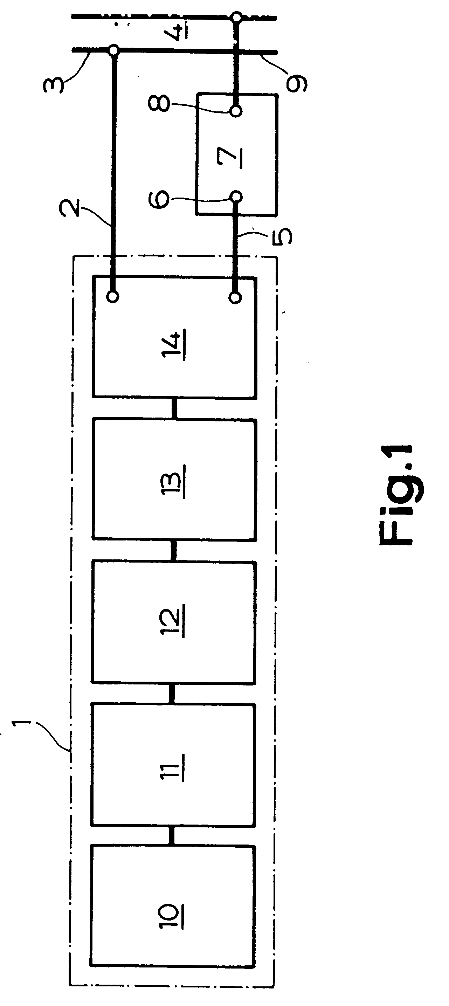

Das in Fig. 1 mit Hilfe eines Blockschaltbildes dargestellte elektronische Schaltgerät 1 arbeitet berührungslos, d. h. es spricht z. B. auf ein sich annäherndes, nicht dargestelltes Metallteil an, und ist im dargestellten Ausführungsbeispiel über einen Außenleiter 2 an einen Pol 3 einer Betriebsspannungsquelle 4 und nur über einen weiteren Außenleiter 5 an einen Anschluß 6 eines Verbrauchers 7 angeschlossen, - während der andere Anschluß 8 des Verbrauchers 7 an den anderen Pol 9 der Betriebsspannungsquelle 4 angeschlossen ist. Mit anderen Worten ist das dargestellte Schaltgerät 1 in bekannter Weise über insgesamt nur zwei Außenleiter 2, 5 einerseits an die Betriebsspannungsquelle 4 und andererseits an den Verbraucher 7 angeschlossen.

Wie Fig. 1 zeigt, besteht das dargestellte Schaltgerät 1 in seinem grundsätzlichen Aufbau aus einem von außen beeinflußbaren Anwesenheitsindikator 10, z. B. einem Oszillator, einem dem Anwesenheitsindikator 10 nachgeordneten Schaltverstärker 11, einem von dem Anwesenheitsindikator 10 über den Schaltverstärker 11 steuerbaren elektronischen Schalter 12, z. B. einem Thyristor, und einer Speiseschaltung 13 zur Darstellung der Speisespannung für den Anwesenheitsindikator 10 und den Schaltverstärker 11. Eingangsseitig ist noch eine Gleichrichterbrücke 14 vorgesehen, weil es sich bei der Betriebsspannungsquelle 4 um eine Wechselspannungsquelle handelt.

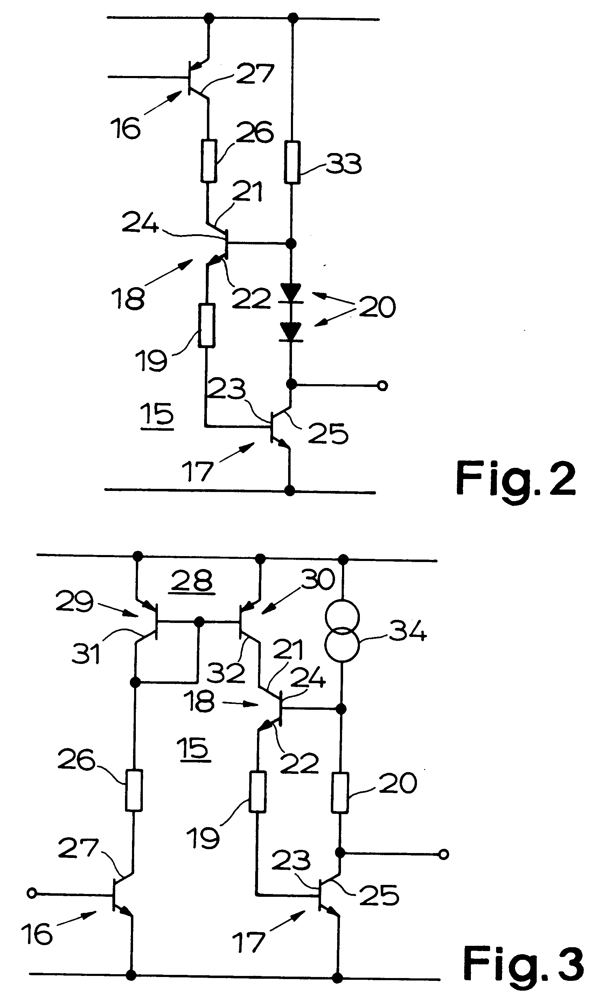

Die Fig. 2 und 3 zeigen nun jeweils ein Ausführungsbeispiel einer zum Schaltverstärker 11 gehörenden Ausgangsstufe 15 mit einem Ansteuertransistor 16 und einem dem Ansteuertransistor 16 nachgeschalteten Ausgangstransistor 17.

Für das erfindungsgemäße, in Fig. 1 dargestellte elektronische Schaltgerät 1 gilt nun zunächst, wie die Fig. 2 und 3 zeigen, daß dem Ausgangstransistor 17 ein Hilfstransistor 18, ein Hilfswiderstand 19 und ein Spannungserhöhungselement 20 zugeordnet ist und daß der Kollektor 21 des Hilfstransistors 18 von dem Ansteuertransistor 16 angesteuert ist, der Hilfswiderstand 19 einerseits an den Emitter 22 des Hilfstransistors 18 und andererseits an die Basis 23 des Ausgangstransistors 17 angeschlossen ist sowie das Spannungserhöhungselement 20 einerseits mit der Basis 24 des Hilfstransistors 18 und andererseits mit dem Kollektor 25 des Ausgangstransistors 17 verbunden ist. Dabei ist das Spannungserhöhungselement 20 ein passives Bauelement, das sicherstellt, daß die Basis 24 des Hilfstransistors 18 potentialmäßig dem Kollektor 25 des Ausgangstransistors 17 folgt, jedoch jeweils um eine durch das Spannungserhöhungselement 20 vorgegebene Spannung über dem Potential des Kollektors 25 des Ausgangstransistors 17 liegt.

Bei dem erfindungsgemäßen elektronischen Schaltgerät 1 wird dem Ausgangstransistor 17 stets nur soviel Ansteuerstrom geliefert, wie er in seiner durch die Belastung im Kollektor-Emitter-Kreis bedingten Funktion benötigt, - und zwar dadurch, daß die Kollektor-Emitter-Spannung $U_{CE}$ des Ausgangstransistors 17 geregelt wird, beispielsweise auf einen Wert $U_{CE} \leq 0,8$ V.

Die Fig. 2 und 3 zeigen nun insoweit bevorzugte Ausführungsbeispiele des erfindungsgemäßen, in Fig. 1 dargestellten elektronischen Schaltgerätes 1, als zunächst ein Ansteuerstrombegrenzungswiderstand 26 vorgesehen ist. Im Ausführungsbeispiel nach Fig. 2 ist der Ansteuerstrombegrenzungswiderstand 26 einerseits an den Kollektor 27 des Ansteuertransistors 16 und andererseits an den Kollektor 21 des Hilfstransistors 18 angeschlossen. Demgegenüber gilt für das Ausführungsbeispiel nach Fig. 3, daß zwischen dem Ansteuertransistor 16 und dem Ausgangstransistor 17 ein Stromspiegel 28 mit einem primären Stromspiegeltransistor 29 und einem sekundären Stromspiegeltransistor 30 vorgesehen ist und daß die Kollektor-Emitter-Strecke des Ansteuertransistors 16 im Kollektorkreis des primären Stromspiegeltransistors 29 liegt, der Ansteuerstrombegrenzungswiderstand 26 einerseits an den Kollektor 27 des Ansteuertransistors 16 und andererseits an den Kollektor 31 des primären Stromspiegeltransistors 29 angeschlossen ist und der Kollektor 32 des sekundären Stromspiegeltransistors 30 mit dem Kollektor 21 des Hilfstransistors 18 verbunden ist.

Weiter oben ist bereits ausgeführt worden, daß das Spannungserhöhungselement 20 ein passives Bauelement ist, das sicherstellt, daß die Basis 24 des Hilfstransistors 18 potentialmäßig dem Kollektor 25 des Ausgangstransistors 17 folgt. Im Ausführungsbeispiel nach Fig. 1 sind als Spannungserhöhungselement 20 zwei Dioden vorgesehen. Demgegenüber zeigt die Fig. 3 ein Ausführungsbeispiel, bei dem als Spannungserhöhungselement 20 ein Widerstand vorgesehen ist. Da das Spannungserhöhungselement 20 ein passives Bauelement ist, wird die erforderliche Spannungserhöhung nur dann erreicht, wenn über das Spannungserhöhungselement 20 ein Spannungserhöhungsstrom fließt. Dazu ist im Ausführungsbeispiel nach Fig. 2 ein Stromversorgungswiderstand 33 vorgesehen, während im Ausführungsbeispiel nach Fig. 3 dem Spannungserhöhungselement 20 ein Konstantstromgenerator 34 vorgeschaltet ist.

**Patentansprüche**

1. Elektronisches, vorzugsweise berührungslos arbeitendes Schaltgerät, mit einem von außen beeinflußbaren Anwesenheitsindikator (10), z. B. einem Oszillator, mit einem dem Anwesenheitsindikator (10) nachgeordneten Schaltverstärker (11) mit einem von dem Anwesenheitsindikator (10) über den Schaltverstärker (11) steuerbaren elektronischen Schalter (12), z. B. einem Transistor, einem Thyristor oder einem Triac, mit einer Speiseschaltung (13) zur Darstellung der Speisespannung für den Anwesenheitsindikator (10) und für den Schaltverstärker (11), bei dem der Schaltverstärker (11) eine Ausgangsstufe (15) mit mindestens einem Ansteuertransistor (16) und einem dem Ansteuertransistor (16) nachgeschalteten Ausgangstransistor (17) aufweist, **dadurch gekennzeichnet**, daß dem Ausgangstransistor (17) ein Hilfstransistor (18), ein Hilfswiderstand (19) und ein passives Spannungserhöhungselement (20), z. B. eine Diode, eine Zenerdiode oder ein Widerstand, zugeordnet ist und daß der Kollektorstrom des Hilfstransistors (18) - direkt oder indirekt - durch den Ansteuertransistor (16) geschaltet ist, der Hilfswiderstand (19) einerseits an den Emitter (22) des Hilfstransistors (18) und andererseits an die Basis (23) des Ausgangstransistors (17) angeschlossen ist und der Basisstrom des Ausgangstransistors (17) ausschließlich durch den Emitterstrom des Hilfstransistors (18) gebildet ist sowie das Spannungserhöhungselement (20) einerseits mit der Basis (24) des Hilfstransistors (18) und einer Stromquelle (33, 34), andererseits mit dem Kollektor (25) des Ausgangstransistors (17) verbunden ist, so daß die Basis des Hilfstransistors (18) potentialmäßig dem Kollektor (25) des Ausgangstransistors (17) folgt, jedoch um eine durch das Spannungserhöhungselement (20) vorgegebene Spannung über dem Potential des Kollektors (25) liegt.

2. Elektronisches Schaltgerät nach Anspruch 1, dadurch gekennzeichnet, daß, wie an sich bekannt, ein Ansteuerstrombegrenzungswiderstand (26) vorgesehen ist.

3. Elektronisches Schaltgerät nach Anspruch 2, dadurch gekennzeichnet, daß der Ansteuerstrombegrenzungswiderstand (26) einerseits an den Kollektor (27) des Ansteuertransistors (16) und andererseits an den Kollektor (21) des Hilfstransistors (18) angeschlossen ist.

4. Elektronisches Schaltgerät nach Anspruch 1 oder 2, dadurch gekennzeichnet, daß, wie an sich bekannt, zwischen dem Ansteuertransistor (16) und dem Ausgangstransistor (17) ein Stromspiegel (28) vorgesehen ist.

5. Elektronisches Schaltgerät nach Anspruch 4, dadurch gekennzeichnet, daß die Kollektor-Emitter-Strecke des Ansteuertransistors (16) im Kollektorkreis des primären Stromspiegeltransistors (29) liegt, der Ansteuerstrombegrenzungswiderstand (26) einerseits an den Kollektor (27) des Ansteuertransistors (16) und andererseits an den Kollektor (31) des primären Stromspiegeltransistors (29) angeschlossen ist und der Kollektor (32) des sekundären Stromspiegeltransistors (30) mit dem Kollektor (21) des Hilfstransistors (18) verbunden ist.

6. Ausgangsstufe eines Schaltverstärkers, mit mindestens einem Ansteuertransistor (16) und einem dem Ansteuertransistor nachgeschalteten Ausgangstransistor (17), **dadurch gekennzeichnet**, daß dem Ausgangstransistor (17) ein Hilfstransistor (18), ein Hilfswiderstand (19) und ein passives Spannungserhöhungselement (20), z. B. eine Diode, eine Zenerdiode oder ein Widerstand, zugeordnet ist und daß der Kollektorstrom des Hilfstransistors (18) - direkt oder indirekt - durch den Ansteuertransistor (16) geschaltet ist, der Hilfswiderstand (19) einerseits an den Emitter (22) des Hilfstransistors (18) und andererseits an die Basis (23) des Ausgangstransistors (17) angeschlossen ist und der Basisstrom des Ausgangstransistors (17) ausschließlich durch den Emitterstrom des Hilfstransistors (18) gebildet ist sowie das Spannungserhöhungselement (20) einerseits mit der Basis (24) des Hilfstransistors (18) und einer Stromquelle (33, 34), andererseits mit dem Kollektor (25) des Ausgangstransistors (17) verbunden ist, so daß die Basis des Hilfstransistors (18) potentialmäßig dem Kollektor (25) des Ausgangstransistors (17) folgt, jedoch um eine durch das Spannungserhöhungselement (20) vorgegebene Spannung über dem Potential des Kollektors (25) liegt.

**7.** Ausgangsstufe nach Anspruch 6, dadurch gekennzeichnet, daß, wie an sich bekannt, ein Ansteuerstrombegrenzungswiderstand (26) vorgesehen ist.

**8.** Ausgangsstufe nach Anspruch 7, dadurch gekennzeichnet, daß der Ansteuerstrombegrenzungswiderstand (26) einerseits an den Kollektor (27) des Ansteuertransistors (16) und andererseits an den Kollektor (21) des Hilfstransistors (18) angeschlossen ist.

**9.** Ausgangsstufe nach Anspruch 6 oder 7, dadurch gekennzeichnet, daß, wie an sich bekannt, zwischen dem Ansteuertransistor (16) und dem Ausgangstransistor (17) ein Stromspiegel (28) vorgesehen ist.

**10.** Ausgangsstufe nach Anspruch 9, dadurch gekennzeichnet, daß die Kollektor-Emitter-Strecke des Ansteuertransistors (16) im Kollektorkreis des primären Stromspiegeltransistors (29) liegt, der Ansteuerstrombegrenzungswiderstand (26) einerseits an den Kollektor (27) des Ansteuertransistors (16) und andererseits an den Kollektor (31) des primären Stromspiegeltransistors (29) angeschlossen ist und der Kollektor (32) des sekundären Stromspiegeltransistors (30) mit dem Kollektor (21) des Hilfstransistors (18) verbunden ist.

## Claims

**1.** An electronic switching unit, preferably operating without contact, with an externally influenceable presence indicator (10), e.g. an oscillator, with a switching amplifier (11) connected downstream of the presence indicator (10), with an electronic switch (12), e.g. a transistor, a thyristor or a triac, which can be controlled by the presence indicator (10) via the switching amplifier (11), with a supply circuit (13) for producing the supply voltage for the presence indicator (10) and for the switching amplifier (11), wherein the switching amplifier (11) has an output stage (15) with at least one drive transistor (16) and an output transistor (17) connected downstream of the drive transistor (16), characterised in that an auxiliary transistor (18), an auxiliary resistor (19) and a passive voltage booster element (20), e.g. a diode, a Zener diode or a resistor, are associated with the output transistor (17) and that the collector current of the auxiliary transistor (18) is switched - directly or indirectly - by the drive transistor (16), the auxiliary resistor (19) is connected on one side to the emitter (22) of the auxiliary transistor (18) and on the other side to the base (23) of the output transistor (17) and the base current of the output transistor (17) is formed exclusively by the emitter current of the auxiliary transistor (18), and the voltage booster element (20) is connected on one side to the base (24) of the auxiliary transistor (18) and to a source of current (33, 34) and on the other side to the collector (25) of the output transistor (17), so that the base of the auxiliary transistor (18) follows the collector (25) of the output transistor (17) with regard to potential, but is above the potential of the collector (25) by a voltage which is predetermined by the voltage booster element (20).

**2.** An electronic switching unit according to claim 1, characterised in that a drive current limiting resistor (26) is provided as is known in the art.

**3.** An electronic switching unit according to claim 2, characterised in that the drive current limiting resistor (26) is connected on one side to the collector (27) of the drive transistor (16) and on the other side to the collector (21) of the auxiliary transistor (18).

**4.** An electronic switching unit according to claim 1 or 2, characterised in that a current reflector (28) is provided between the drive transistor (16) and the output transistor (17) as is known in the art.

**5.** An electronic switching unit according to claim 4, characterised in that the collector-emitter section of the drive transistor (16) is situated in the collector circuit of the primary current reflector transistor (29), the drive current limiting resistor (26) is connected on one side to the collector (27) of the drive transistor (16) and on the other side to the collector (31) of the primary current reflector transistor (29), and the collector (32) of the secondary current reflector transistor (30) is connected to the collector (21) of the auxiliary transistor (18).

**6.** An output stage of a switching amplifier, with at least one drive transistor (16) and an output transistor (17) connected downstream of the drive transistor, characterised in that an auxiliary transistor (18), an auxiliary resistor (19) and a passive voltage booster element (20), e.g. a diode, a Zener diode or a resistor, are associated with the output transistor (17) and that the collector current of the auxiliary transistor (18) is switched - directly or indirectly - by the drive transistor (16), the auxiliary resistor (19) is connected on one side to the emitter (22) of the auxiliary transistor (18) and on the other side to the base (23) of the output transistor (17) and the base current of the output transistor (17) is formed exclusively by the emitter current of the auxiliary transistor (18), and the voltage booster element (20) is connected on one side to the base (24) of the auxiliary transistor (18) and to a source of current (33, 34) and on the other side to the collector (25) of the output transistor (17), so that the base of the auxiliary transistor (18) follows the collector (25) of the output transistor (17) with regard to potential, but is above the potential of the collector (25) by a voltage which is predetermined by the voltage booster element (20).

7. An output stage according to claim 6, characterised in that a drive current limiting resistor (26) is provided, as is known in the art.

8. An output stage according to claim 7, characterised in that the drive current limiting resistor (26) is connected on one side to the collector (27) of the drive transistor (16) and on the other side to the collector (21) of the auxiliary transistor (18).

9. An output stage according to claim 6 or 7, characterised in that a current reflector (28) is provided between the drive transistor (16) and the output transistor (17) as is known in the art.

10. An output stage according to claim 9, characterised in that the collector-emitter section of the drive transistor (16) is situated in the collector circuit of the primary current reflector transistor (29), the drive current limiting resistor (26) is connected on one side to the collector (27) of the drive transistor (16) and on the other side to the collector (31) of the primary current reflector transistor (29), and the collector (32) of the secondary current reflector transistor (30) is connected to the collector (21) of the auxiliary transistor (18).

**Revendications**

1. Appareil de couplage électronique travaillant de préférence sans contact, comprenant un indicateur de présence (10) influençable de l'extérieur, par exemple un oscillateur; un amplificateur de commutation (11) monté en aval de l'indicateur de présence (10), équipé d'un commutateur électronique (12) commandé par l'indicateur de présence (10) à travers l'amplificateur de commutation (11), par exemple un transistor, un thyristor ou un triac; un câblage d'alimentation (13) pour procurer la tension d'alimentation à l'indicateur de présence (10) et à l'amplificateur de commutation (11), dans lequel l'amplificateur de commutation (11) présente un étage de sortie (15) comprenant au moins un transistor d'excitation (16) et un transistor de sortie (17) monté en aval du transistor d'excitation (16), caractérisé en ce qu'un transistor auxiliaire (18), une résistance auxiliaire (19) et un élément passif (20) d'augmentation de tension, par exemple une diode, une diode Zener ou une résistance, sont attribués au transistor de sortie (17) et en ce que le courant collecteur du transistor auxiliaire (18) est couplé - directement ou indirectement - à l'intervention du transistor d'excitation (16), la résistance auxiliaire (19) est raccordée d'une part à l'émetteur (22) du transistor auxiliaire (18) et d'autre part à la base (23) du transistor de sortie (17), et le courant de base du transistor de sortie (17) est formé exclusivement par le courant émetteur du transistor auxiliaire (18); de la même manière, l'élément d'augmentation de tension (20) est relié d'une part à la base (24) du transistor auxiliaire (18) et à une source de courant (33, 34), d'autre part au collecteur (25) du transistor de sortie (17), si bien que la base du transistor auxiliaire (18) suit, du point de vue du potentiel, le collecteur (25) du transistor de sortie (17), tout en se situant toutefois au-delà du potentiel du collecteur (25), d'une tension prédéfinie par l'élément d'augmentation de tension (20).

2. Appareil de couplage électronique selon la revendication 1, caractérisé en ce que, comme il est connu en soi, on prévoit une résistance (26) de limitation du courant d'excitation.

3. Appareil de couplage électronique selon la revendication 2, caractérisé en ce que la résistance (26) de limitation du courant d'excitation est raccordée d'une part au collecteur (27) du transistor d'excitation (16) et d'autre part au collecteur (21) du transistor auxiliaire (18).

4. Appareil de couplage électronique selon la revendication 1 ou 2, caractérisé en ce que, comme il est connu en soi, entre le transistor d'excitation (16) et le transistor de sortie (17), on prévoit un réflecteur de courant (28).

5. Appareil de couplage électronique selon la revendication 4, caractérisé en ce que le tronçon collecteur-émetteur du transistor d'excitation (16) se situe dans le circuit collecteur du transistor primaire de réflecteur de courant (29), la résistance (26) de limitation de courant d'excitation est raccordée d'une part au collecteur (27) du transistor d'excitation (16) et d'autre part au collecteur (31) du transistor primaire de réflecteur de courant (29), et le collecteur (32) du transistor secondaire de réflecteur de courant (30) est relié au collecteur (21) du transistor auxiliaire (18).

6. Etage de sortie d'un amplificateur de commutation comprenant au moins un transistor d'excitation (16) et un transistor de sortie (17) monté en aval du transistor d'excitation, caractérisé en ce qu'un transistor auxiliaire (18), une résistance auxiliaire (19) et un élément passif (20) d'augmentation de tension, par exemple une diode, une diode Zener ou une résistance, sont attribués au transistor de sortie (17) et en ce que le courant collecteur du transistor auxiliaire (18) est couplé - directement ou indirectement - à l'intervention du transistor d'excitation (16), la résistance auxiliaire (19) est raccordée d'une part à l'émetteur (22) du transistor auxiliaire (18) et d'autre part à la base (23) du transistor de sortie (17), et le courant de base du transistor de sortie (17) est formé exclusivement par le courant émetteur du transistor auxiliaire (18); de la même manière, l'élément d'augmentation de tension (20) est relié d'une part à la base (24) du transistor auxiliaire (18) et à une source de courant (33, 34), d'autre part au collecteur (25) du transistor de sortie (17), si bien que la base du transistor auxiliaire (18) suit, du point de vue du potentiel, le collecteur (25) du transistor de sortie (17), tout en se situant toutefois au-delà du potentiel du collecteur (25), d'une tension prédéfinie par l'élément d'augmentation de tension (20).

7. Etage de sortie selon la revendication 6, caractérisé en ce que, comme il est connu en soi, on prévoit une résistance (26) de limitation du courant d'excitation.

8. Etage de sortie selon la revendication 7, caractérisé en ce que la résistance (26) de limitation du courant d'excitation est raccordée d'une part au collecteur (27) du transistor d'excitation (16) et d'autre part au collecteur (21) du transistor auxiliaire (18).

9. Etage de sortie selon la revendication 6 ou 7, caractérisé en ce que, comme il est connu en soi, entre le transistor d'excitation (16) et le transistor de sortie (17), on prévoit un réflecteur de courant (28).

10. Etage de sortie selon la revendication 9, caractérisé en ce que le tronçon collecteur-émetteur du transistor d'excitation (16) se situe dans le circuit collecteur du transistor primaire de réflecteur de courant (29), la résistance (26) de limitation de courant d'excitation est raccordée d'une part au collecteur (27) du transistor d'excitation (16) et d'autre part au collecteur (31) du transistor primaire de réflecteur de courant (29), et le collecteur (32) du transistor secondaire de réflecteur de courant (30) est relié au collecteur (21) du transistor auxiliaire (18).

Fig.1

Fig.2

Fig.3